Europäisches Patentamt

European Patent Office

Office européen des brevets

(11) Publication number: **0 183 598**
A2

## EUROPEAN PATENT APPLICATION

(21) Application number: **85402171.4**

(22) Date of filing: **12.11.85**

(51) Int. Cl.⁴: **H 01 L 23/48**
**H 01 L 23/56**

(30) Priority: **13.11.84 US 670818**

(43) Date of publication of application:
**04.06.86 Bulletin 86/23**

(84) Designated Contracting States:
**DE FR GB**

(71) Applicant: **AUGAT INC.**
**89 Forbes Boulevard**
**Mansfield Massachusetts 02048(US)**

(72) Inventor: **Lebow, Sandford**
**2791 Lakeridge Lane**
**Westlake Village California 91361(US)**

(74) Representative: **Descourtieux, Philippe et al,**
**CABINET BEAU de LOMENIE 55 rue d'Amsterdam**
**F-75008 Paris(FR)**

(54) A shielded integrated circuit package.

(57) An RF, EMI shielded printed circuit package (10) is provided by embedding within a plastic substrate (12) an electrically-conductive cup (14) having an inwardly-running lip (10) at the top surface of the plastic substrate (12). An electrically-conductive cap (14) is mechanically and electrically secured to the inner edge of the lip (16) of the embedded cup (14), thereby to form a completely RF, EMI shielded cavity in which is placed an integrated circuit chip (22), with the lip (16) carrying external coaxial contact pads (36). Connection to the integrated circuit chip (22) is from contact pads (36) formed in the inwardly-running lip (16) of the cup (14) and is made via internal integral coaxial cable-like components such that the chip (22) may be connected to an external coaxial cable via coaxial cable-like structures running from the external contact pads (36) on the lip (16) through the plastic substrate (12) to internal contact pads (24) adjacent the integrated circuit chip (22). In one embodiment, a plasma etching step is performed after chemical development to increase pattern definition. The purpose of plasma etching is to clean up any microscopic organic contamination that has not been adequately removed by the developing step in the printing. In addition, the plasma etch provides very clean edge definition; so, when doing "additive" plating, no irregularities on the conductor edges are formed, which irregularities in high-speed applications impede the flow of electrons.

./...

*Fig. 1*

## FIELD OF INVENTION

This invention relates to the packaging of integrated circuits and, more particularly, to an integrated circuit package with built-in RF, EMI shielding, in which the integrated circuit is completely surrounded by an electrically-conductive enclosure.

## BACKGROUND OF THE INVENTION

Major semiconductor manufacturers have for many years provided integrated circuits having large pin counts. In order to accommodate the large number of pins, in the past semiconductor manufacturers have provided leadless chip carriers, or packages. As the pin count increased, the manufacturers provided "pin grid arrays" on ceramic, with the maximum size of a leadless chip carrier being on the order of 84 pins. Moreover, these pin grid arrays had 100 mil grids with leads coming out of the package on a 50 mil grid pattern. In order to increase the number of pins, it turned out not to be possible to make the carriers out of ceramic and maintain the tolerances commensurate with a higher pin count device. The result was to make the ceramic chip carriers larger. As the ceramic chip carriers grew larger, i.e., 1.5 inches x 1.5 inches, it became much more difficult to maintain tolerances during firing. In the intervening time, large gate arrays came into existence which required as many as 220 pins. Thus it was desirable to increase the number of pins to, for instance, 200 to 400 pins on as fine as 10-12 1/2 mil centers, i.e. 10-12 1/2 mil "pitches" and such was not possible using ceramic packaging techniques.

The ceramic pin grid array technique was rejected for this application for a number of reasons. First and foremost in ceramics, the inductance of pin grid arrays runs from 4-5 nanohenries and the capacitance runs from 2-4 picofarads. The inductance and capacitance effects are deleterious for large gate arrays because of drastic speed reduction and overheating problems. With respect to speed, it is important to be able to reduce the inductance to less than 2 nanohenries in one inch of length and to reduce the capacitance to under 1 1/2 picofarads. It is also important to be able to fabricate a carrier having input-output coax leads on a 20 mil pitch or less, which is impossible to do in ceramic-type carriers. The best ceramic carrier manufacturers are able to achieve a 25 mil pitch for noncoaxial leads, but as mentioned above the required performance characteristics cannot be met in ceramics.

What will be apparent is that, if there is a requirement for a large number of leads and there is a deterioration in performance due to the impedance characteristics of the ceramic carrier, only very slow speed applications can be accommodated through the use of ceramic-type products. However, for large gate arrays mentioned above, high speed, high density and thermal dissipation are required. In other words, speed, density, thermal dispersion and hermeticity must be dealt with when contemplating packaging for such high density arrays.

It will also be appreciated that in the ceramic chip carrier prior art, the leads from the internally-contained chip to the external contact pads are noncoaxial in nature. Thus even if coax is connected to the prior art chip carrier, there is a large impedance mismatch at the external contact pad since internal coaxial cables are not provided between the external contact pad and the integrated circuit chip within the carrier.

Perhaps more importantly, none of the carriers mentioned above provide for electromagnetic interference (EMI) shielding or radio frequency (RF) shielding. It is of course possible to place an unshielded package of the prior art design within a can or electrically-conductive container, but such containers are bulky and, in general, do not lend themselves well to the types of applications requiring high density, integrated circuits.

By way of further background, there is a method of manufacturing plastic multilayer integrated circuits described in U.S. Patents 4,306,925 and 4,159,222 and assigned to the assignee hereof in which high density, fine line printed circuitry is achieved through a so-called "additive" process in which multiple laminations of materials such as polyimides are interspersed with patterned metallizations which provide vias or contact posts which project through the layered polyimides to achieve printed circuit board type structures of a multilayer variety. While this technology has proved successful in providing a 20 mil pitch or line density, considerations of EMI or RF shielding are not addressed in these patents. Moreover, the necessity of forming coaxial cables within a printed circuit package to improve impedance characteristics is not described in any of the aforementioned prior art.

SUMMARY OF THE INVENTION

Unlike integrated chip carriers of the ceramic type and even unlike plastic chip carriers, in the subject invention plastic chip carriers are provided with an internal metal cup and overlying metal cap to provide complete EMI and RF shielding. The carriers utilize the technology of the aforementioned patents, augmented by a plasma etching step to provide 20 mil pitches or less. The subject integrated circuit chip carrier is capable of accommodating high density, integrated circuits in which improved impedance characteristics due to the RF and EMI shielding permit maximum speed when using high density, integrated circuits while at the same time providing for the dissipation of thermal energy generated by the high speed devices.

More particularly, the subject package
includes the feature of providing within a laminated
plastic structure a continuous electrically-conductive
cup which is embedded in the plastic material. The cup
has an inwardly-directed lip and coaxial leads are provided from the lip through the plastic layers and to the
integrated circuit. While not all leads need be coaxial
in terms of connection of the integrated circuit chip to
external circuitry, the utilization of coaxial leads
embedded within the package provides a certain degree of
impedance matching such that the termination impedance
characteristics can be tailored for the particular device.

Thus the device described thus far includes the concept of embedding an electrically-conductive
cup with a circumferential lip in a plastic layered
structure. The RF and EMI shielding is completed by
electrically and mechanically attaching to this inwardly-
directed lip an electrically-conductive cap in so that
the internally-carried integrated circuit device is
surrounded with an electrically-conductive enclosure.
In one aspect, the subject invention may be viewed as
having an internally-formed, electrically-conductive,
continuous cap embedded in a plastic substrate which is
layered ; and an electrically-conductive cap is secured
to an inwardly-directed lip of the cup, such that RF and
EMI shielding is provided. Crosstalk is eliminated by the
aforementioned coaxial structures which are formed within
the embedded cup. These structures run from the external
coax contact pads to the internally-carried chip, thus
to be able to take advantage of the increased speed of the
aforementioned high density devices.

In one embodiment, the integrated circuit
chip is supported on thermally-conductive posts which run
from the bottom of the embedded cup to the position at
which the chip is mounted. The bottom of the cup may itself be exposed at the bottom of the plastic layer; and this bottom, in one embodiment, may be coupled to an extensive heat sink structure, thereby to dissipate the heat generated by the high density integrated circuit contained within in the cup.

As an alternative to the thermally-conductive posts mentioned hereinbefore, the integrated circuit chip can be made to rest on the bottom of the internally-carried cup such that the integrated circuit is in intimate contact with the bottom of the cup. Thermal energy is transferred from the chip through the cup to a thermal heat sink which may be in the form of a relatively thick copper layer provided at the base of the carrier and is secured to the laminated plastic structure at its bottom surface.

In a still further embodiment, the inwardly-directed lip may contain perforations which provide paths for solvents to escape during lamination and cure cycles which are necessary in the formation of the carrier itself. Moreover, the perforations result in a mechanical lock to the plastic laminated structure, thereby providing for a mechanically secure package which does not delaminate easily.

In still further embodiments, an internal ground plane is provided within the laminated plastic structure which forms a further electrically-conductive cup structure to provide increased RF and EMI shielding and therefore increased speed for the high density circuit contained within the package.

In summary, what is provided is extremely fine line definition through the utilization of the technology of the aforementioned patents; RF and EMI shielding which operates to decrease electromagnetic interference; and embedded coaxial cables to provide for better impedance matching, which, inter alia, prevents crosstalk and increases the speed at which the internally-contained devices may be operated.

With respect to the new plasma etching step, this is done after chemical developing and provides for very fine pattern definition to permit the 20 mil pitches or finer, as required.

## BRIEF DESCRIPTION OF THE DRAWINGS

These and other features of the subject invention will be better understood in connection with the detailed description taken in conjunction with the drawings of which :

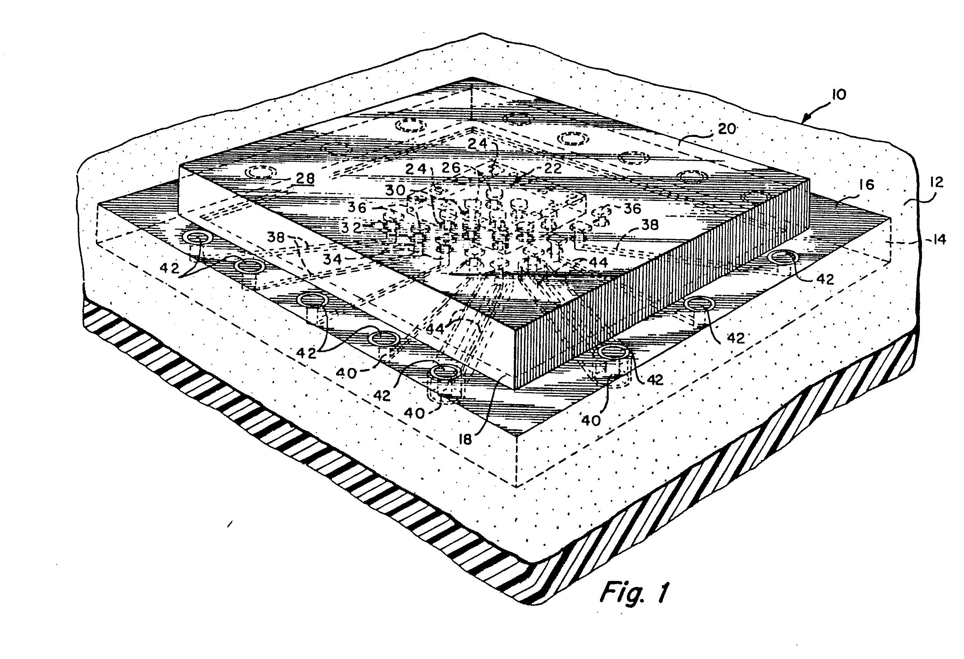

Fig. 1 is a diagrammatic and cross-sectional view of the subject integrated circuit carrier illustrating an embedded cup having an inwardly-directed, laterally-running top surface to which is attached an electrically-conductive cap, with embedded coaxial cables running from the integrated circuit chip contained within the package to external contact pads on the inwardly-directed lip ;

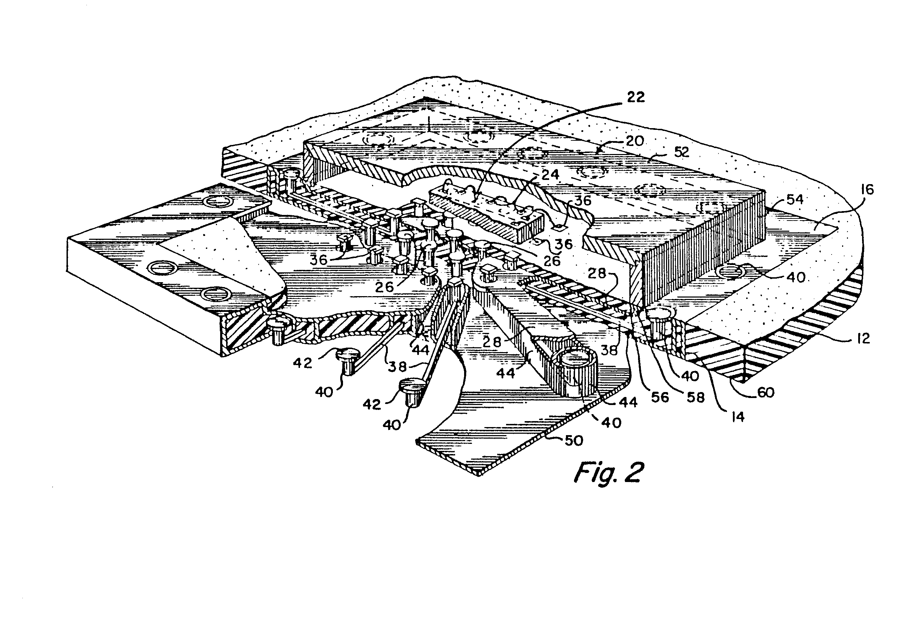

Fig. 2 is a cross-sectional and diagrammatic illustration in cutaway form showing the internal structure of the carrier and integrated circuit chip of Fig. 1, illustrating, inter alia, thermally-conductive posts on which the integrated circuit chip is mounted ;

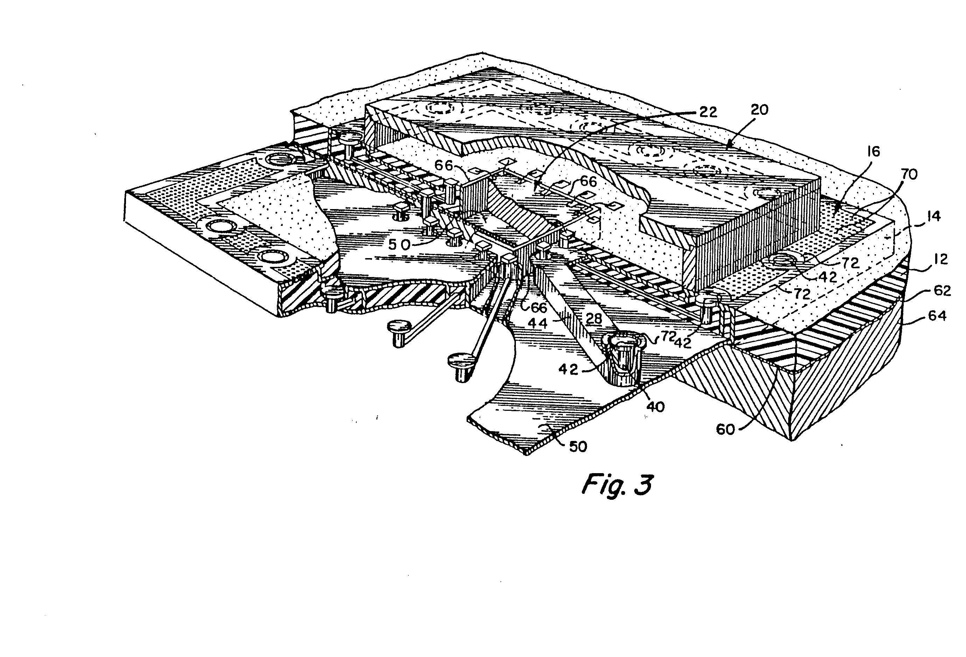

Fig. 3 is a diagrammatic and cross-sectional illustration of another embodiment of the carrier of Fig. 1 illustrating the placement of the integrated circuit chip on the bottom of-the internally-contained cup, also showing a perforated lip structure for providing a path for solvents to escape during the manufacturing process and for providing a mechanical lock to the laminated plastic carrier ;

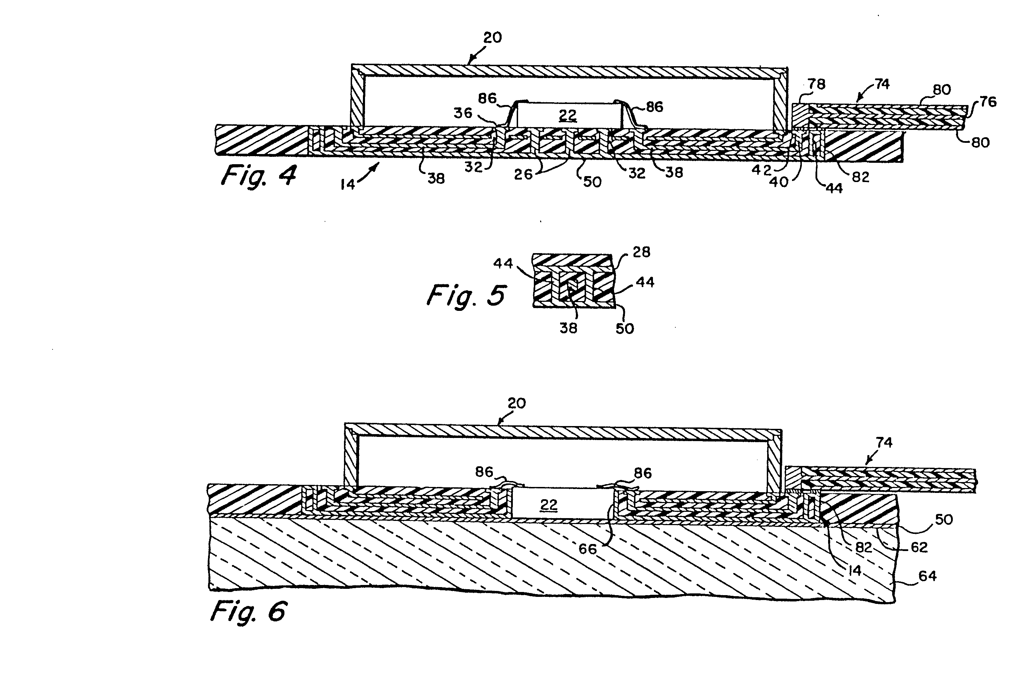

Fig. 4 is a diagrammatic and cross-sectional illustration of a portion of the carrier of Fig. 2 illustrating the coaxial connection of the integrated circuit chip to an external coaxial cable as well as illustrating the support of the integrated circuit chip on thermal vias which are connected electrically and mechanically to the bottom of the embedded cup ;

Fig. 5 is a cross-sectional and diagrammatic illustration of a portion of the coaxial cable which is embedded within the structure illustrating a rectilinear structure for the coaxial cable which runs between the external contact pad and an internal contact pad;

Fig. 6 is a cross-sectional illustration of a portion of the carrier of Fig. 3 illustrating the positioning of the integrated circuit chip on the bottom of the internally-contained cup, also illustrating a thermal heat sink material in intimate contact with the bottom of the cup and therefore with the bottom of the integrated circuit; and

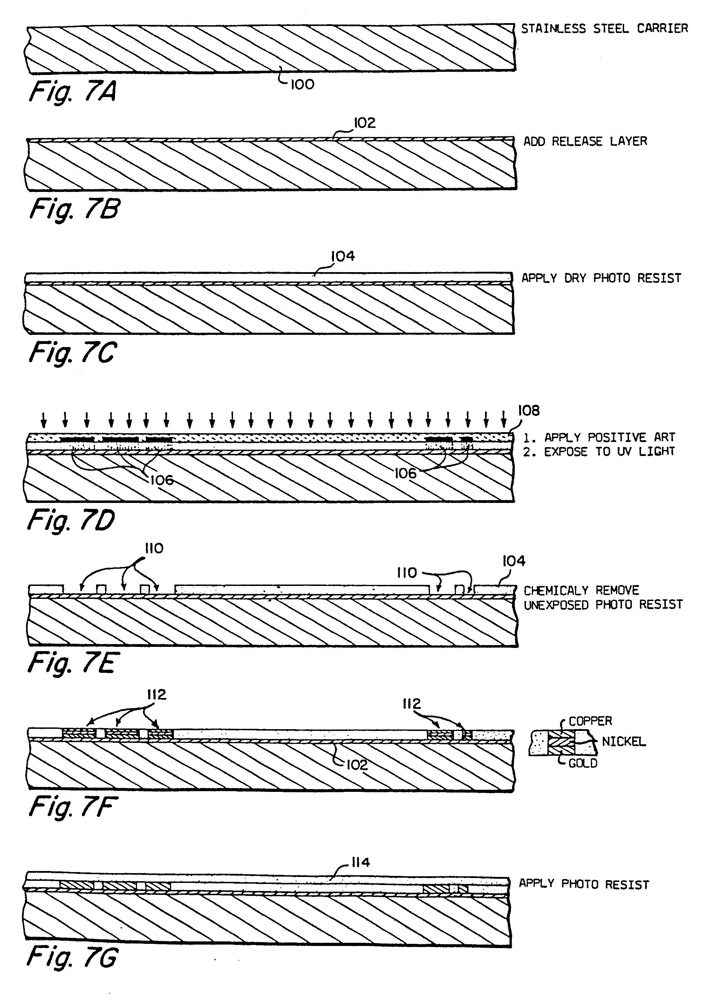

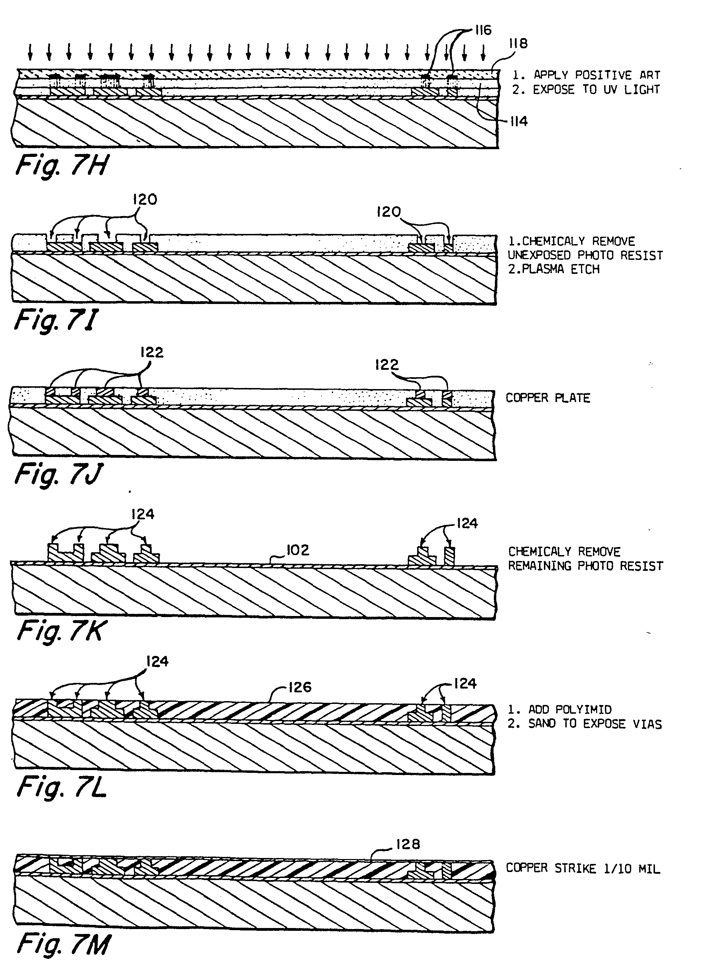

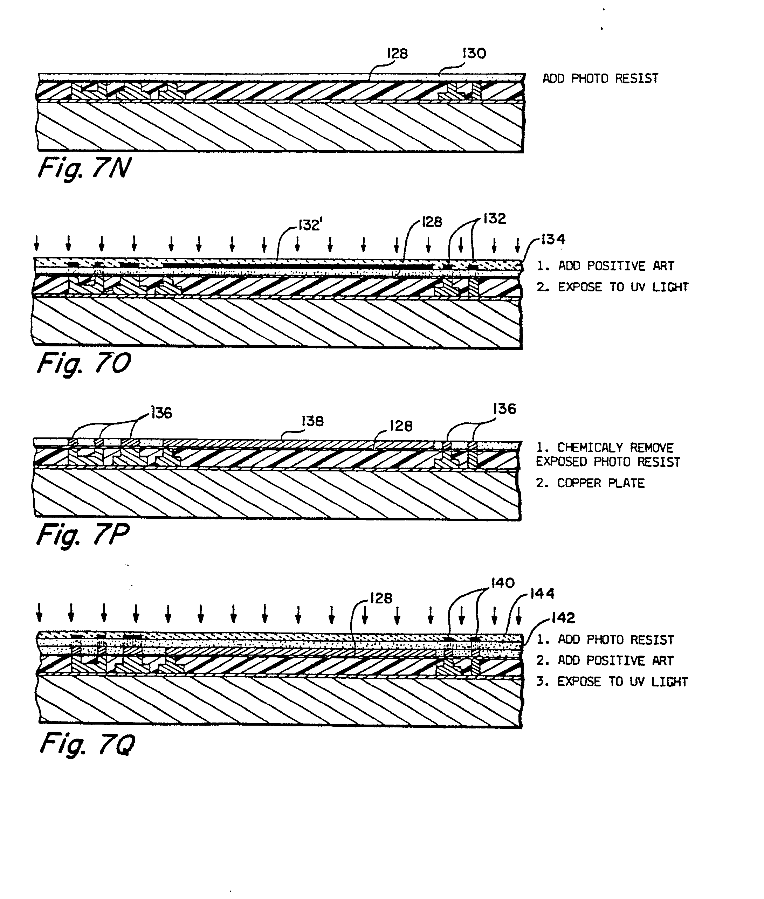

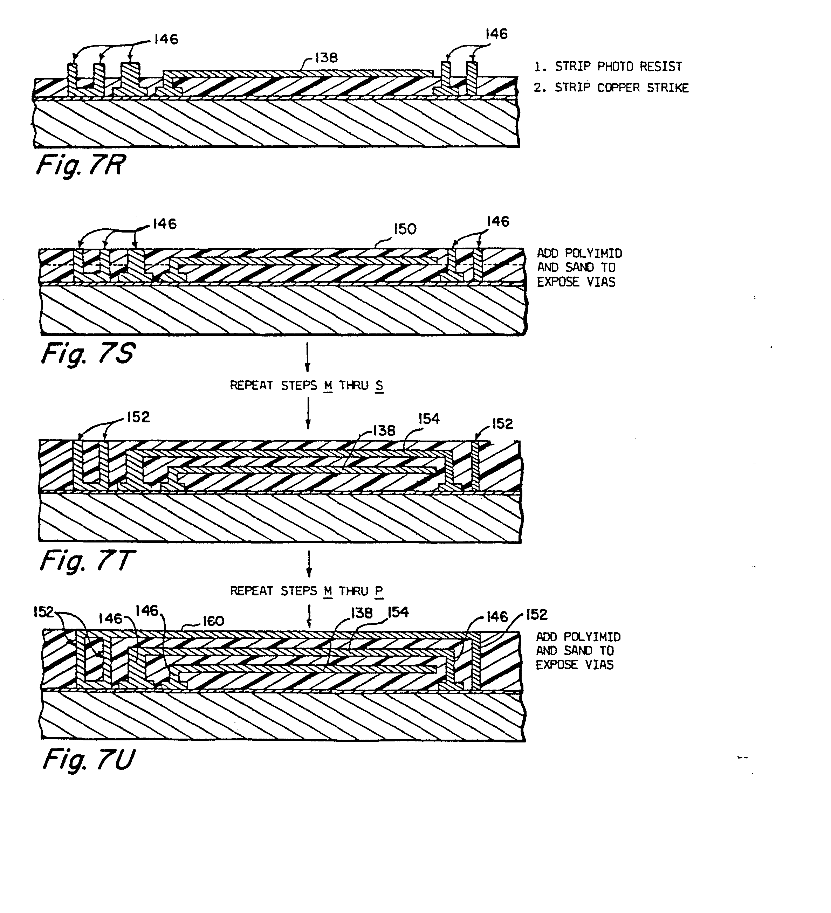

Figs. 7A-7U illustrate diagrammatically the steps utilized in producing the device of Fig. 2 utilizing the technology of the aforementioned patents.

DETAILED DESCRIPTION

Referring now to Fig. 1, an integrated circuit package 10 is illustrated as including a plastic, usually polyimide, substrate 12 having embedded therein an electrically-conductive cup 14 which has a laterally-running lip portion 16 which has a circumferential inner edge illustrated by dotted line 18. A cap 20 which is electrically conductive, is sealed at inner edge 18 to lip 16 such that the cap and cup provide a continous electrically-conductive enclosure, with half of the enclosure being embedded in the substrate.

Within the enclosure is located an integrated circuit chip 22 having contact pads 24 thereon. The integrated circuit chip is supported on thermally-conductive posts 26 which extend through a planar electrically-conductive plate 28 which forms a voltage plane. In one embodiment, this plate is electrically connected to lip 16 and has apertures 30 therethrough to accommodate the thermally-conductive posts.

Apertures 32 are also provided in this plate to accommodate upwardly extending vias 34 which have contact pads 36 thereon and which form the central conductor of an upstanding portion of a coaxial cable-like structure from the vicinity of the integrated circuit chip via a laterally-running central conductor 38 to a vertically-running via 40 which extends upwardly and terminates in a contact pad 42 within the region of the lip external to cap 20.

The outer conductor of the embedded coaxial-like element is illustrated by vertically-running walls 44 which surround each of central conductors 38 during their horizontal run and also surround the vias at either end of conductor 38. Plate 28 forms the top portion of the coaxial cable-like structure. As illustrated in Fig. 2, the bottom 50 of cup 14 forms the bottom wall of the outer conductor for the embedded part of the coaxial cable. Thus, as illustrated in Fig. 5, the internal coaxial cable has a rectilinear cross-section.

Referring back to Fig. 2, it will be appreciated that all of the metal elements are interspersed with a plastic material, in the preferred embodiment a polyimide, a polyamide imide or a polyimide amide, which insulates the respective vias and walls, and strikes, conductors or buses from other metallic or electrically-conductive elements. When, as illustrated in Fig. 2, contact pads 36 are connected to respective contact pads 24 on the integrated circuit chip 22, a coaxial cable-like structure having controlled impedance is provided from the interior of the package to the exterior of the package so that the input impedance to the integrated circuit can be controlled through the package to the point of connection to the integrated circuit.

Referring again to Fig. 2, plastic layer 12 is interspersed between all of the adjacent electrically-conductive elements. Here also cap 20 can be seen as having a top lid 52 and side walls 54 which meet with enlarged flange portions 56 of layer 28 which is vertically extended as can be seen at wall 58. Thus, an inner cup comprising plate 28, upstanding wall 58 and enlarged flange portion 56 is formed.

Also as seen from this figure, bottom 50 of the cup is flush with the bottom 60 of substrate 12 such that heat from integrated circuit chip 22 is conducted via thermal posts 26 down to the bottom 50 of cup 14 where it can be dissipated.

Referring to Fig. 3, the bottom surface 60 of substrate 12 may be provided with a conductive layer 62, usually copper, and a much increased thickness portion 64 to provide additional heat sinking. Also shown in this figure is the fact that chip 22, rather than being located on thermally-conductive posts, rests on bottom 50 with the chip being surrounded by an electrically-conductive wall 66 which runs completely around the integrated circuit chip. It is noted that in both Figs. 2 and 3, insulating material insulates vias 40 and pads 42 from the surrounding metal such that contact pad 42 forms the central conductor of a coaxial cable-like structure. The end of the outer conductor of the cable in Fig. 2 is the top surface of lip 16, as is the case in Fig. 3.

Also what will be seen from Fig. 3 is that the top surface of lip 16 may be perforated as illustrated at 70 to permit gases to escape for the curing process in which the subject devices are manufactured and also to provide for adherence of the lip portion of cup 14 to the plastic therebeneath. Thus, the purpose of the perforation in ground and voltage planes, namely, large masses of metals, is to allow gases and solvents to escape during the curing operation and also to provide good mechanical adhesion or locking of the conductors to the polyimide structure. The perforations preferably should not amount to any more than 40 percent of the total metal area to preserve shielding. It will be noted that surrounding contact pads 42 is a continuous ring 72 of metal in order to permit connection of an external coaxial cable thereto.

Referring to Fig. 4, the internal structure of Fig. 2 is shown with a coaxial cable generally indicated at 74 having a central conductor 76 terminating at an enlarged contact portion 78 which is electrically connected to contact pad 42 on via 40. The outer portion of coaxial cable 74 is illustrated at 80 with a portion of this out cable portion being electrically bonded to cup 14 at wall 82. In this diagram, the central conductors 38 are clearly shown as terminating in upward vias 32, with thermal posts 26 being illustrated as being integral with the bottom 50 of cup 14. Here the connection of chip 22 to respective contact pads 36 is shown by wires 86.

Referring to Fig.5, as mentioned before the internal structure of the internally-carried coaxial cable-like elements is illustrated as being rectilinear.

Referring to Fig. 6, chip 22, as illustrated in Fig. 3, rests on bottom 50 of cup 14, with layer 62 being clearly in evidence as contacting the bottom of the cup, and with auxiliary heat sink means 64 contacting layer 62.

METHOD OF MANUFACTURE

Referring to Figs. 7A through 7U, one method is illustrated for fabrication of a portion of the structure illustrated in Fig. 6 which extends from wall 82 of cup 14 to wall 66 to one side of integrated circuit chip 22 as illustrated at Fig. 7A. It is one of the important features of subject invention that a stainless steel carrier 100 is utilized with a plate-up process on the stainless steel carrier. As illustrated in Fig. 7B, an intermediate lift-off layer 102 of nickel or copper conductive releasing agents is placed on the stainless steel carrier and is relatively thin, on the order of one mil (.001 inch). Referring to Fig. 7C, a dry photoresist 104 is applied over layer 102 and, as illustrated in Fig. 7D, a positive photoresist 106 in a layer 108, usually mylar, forming the positive art is applied to the dry photoresist layer; and the entire structure is exposed to ultraviolet light. As illustrated in Fig. 7E, layer 108 and the areas of the photoresist under pattern 106 are chemically removed to provide apertures 110 in photoresist layer 104. During this step, after development, a plasma etching step sharpens the pattern. In summary, a dry photoresist is applied, then a positive film is laid over it, which is the pattern to be printed. The ultraviolet light is applied which cures the resist except in the area where the positive does not allow light to pass. Then the carrier is developed in a solution which removes the resist that was not cured in the areas to be plated. After resist is developed, the surface of the remaining structure is plasma etched and prepared for plating. Plasma etching involves the application in a vacuum with RF energy gases, such as oxygen and freon. This burns away any microscopic resist or organic material which was not developed out. The purpose of plasma etching is to clean up any microscopic organic contamination that has not been adequately removed by the developing step in the printing. In addition, the plasma etch provides very clean edge definition ; so, when doing "additive" plating, no irregularities on the conductor edges are formed, which irregularities in high-speed applications impede the flow of electrons.

Thereafter, as illustrated in Fig. 7F, vias generally indicated by 112 are provided on top of layer 102 usually by sequential plating of gold, followed by nickel, followed by copper, as illustrated in the diagram immediately to the right of Fig. 7F. Thereafter, as illustrated in Fig. 7G, a photoresist layer 114 is applied across the entire portion of the article thus formed. As illustrated in Fig. 7H, positive art in the form of photoresist 116 embedded in layer 118 is applied at the over photoresist layer 114, with layer 118 being transparent to ultraviolet light. The entire structure is then irradiated with ultraviolet light and, as illustrated in Fig. 7I, the photoresist is chemically removed at regions 120 first, by a chemical dissolving step which removes the unexposed photoresist, and second by a plasma etching step to increase pattern definition. Thereafter, as illustrated in Fig. 7J, copper plating is provided at positions 122. After the copper plating step of Fig. 7J, as illustrated in Fig. 7K, the remaining photoresist is chemically removed so as to provide structures 124 on top of layer 102. As illustrated in Fig. 7L, a layer 126 of plastic, usually polyimide, is provided on top of the entire structure and is sanded down to expose structures 124 which structures constitute the aforementioned vias, walls, strikes or buses, etc.

As illustrated in Fig. 7M, a one-tenth mil copper strike 128 is provided over the structure of Fig. 7L and, as illustrated in Fig. 7N, additional photoresist layer 130 is applied. Thereafter, positive art in the form of photoresist 132 embedded in a transparent layer 134 is applied, with the resulting structure being irradiated with ultraviolet light with the positive art being removed as illustrated in Fig.7P in a chemical process so as to leave not only additional

0183598

height vias 136 but also a voltage plane 138 caused by the positive art portion 132' of Fig. 7 O. The latter vias and voltage plane are provided by copper plating the apertures left by the chemical removal of the exposed photoresist. Here again, plasma etching may be used.

As illustrated in Fig. 7Q, a further layer of art in the form of photoresist 140 embedded in transparent layer 144 is provided on a further layer of photoresist 142 which coats the structure of Fig. 7P. Again, this structure is exposed to ultraviolet light and the positive art is removed via the aforementioned chemical process and/or plasma etching. Secondly, copper strike 128 is subsequently removed so as to provide the structure shown in Fig. 7R with upwardly projecting vias 146 and voltage plane 138 now being exposed.

Referring now to Fig. 7S, another layer of plastic 150 is placed over the structure of Fig. 7R, and steps 7M through 7S are repeated to provide the structure shown in Fig. 7T in which vias 152 are extensions of the formerly formed vias with the resulting structure forming an additional voltage plane 154 having the original voltage plane 138 therebeneath.

Repeating again steps 7M through 7P results in the final structure of Fig. 7U, which results in a portion of the cup here illustrated at 160, with voltage plane 154 and central conductor 138 clearly in evidence. Moreover, vias 146 and 152 are clearly in evidence, thereby completing the formation of the integrated circuit package.

Having above indicated a preferred embodiment of the present invention, it will occur to those skilled in the art that modifications and alternatives can be practiced within the spirit of the invention. It is accordingly intended to define the scope of the invention only as indicated in the following claims.

CLAIMS

What is claimed is :

1.         An RF, EMI shielded integrated circuit package (10) characterized in that it comprises :

a plastic substrate (12),

an electrically-conductive cup (14) embedded in said substrate (12), said cup having an inwardly-directed lip (16) at the top surface of said substrate, said lip (16) having contact pads (36) thereon insulated from the lip surrounding said pads (36);

an electrically-conductive cap (20) electrically and mechanically connected to said lip (16) at a position inward of said contact pads (36) carried by said lip (16);

an integrated circuit (22) having contact pads (24), said circuit being positioned within the structure formed by said cap (20) and said lip (16); and

means for connecting contact pads (24) on said integrated circuit (22) to said contact pads (36) on said lip (16).

2.         The integrated circuit package of claim 1, characterized in that said means for connecting the contact pads (36) on said lip(16) to the contact pads (24) on said integrated circuit (22) include coaxial cable-like structures embedded in said plastic substrate (12) and running from said lip-carried contact pads (36) to the vicinity of said integrated circuit chip (22).

3.         The integrated circuit package of claim 1, characterized in that said cup (14) has a bottom exposed at the bottom surface of said substrate(12), and further including thermally-conductive columns (26) from the base of said cup (14) to the bottom of said integrated circuit (22), whereby heat generated by said integrated circuit is dissipated by the bottom of said cup (14).

4.           The integrated circuit package of claim 1, characterized in that said cup (14) has a bottom (50) and in that said integrated circuit (22) lies on the bottom of said cup (14).

5.           The integrated circuit package of claim 1, characterized in  that said cup (14) has a bottom (50) and in that the bottom surface of said substrate (12) is provided with a thermally conductive layer (62), said thermally conductive layer (62) being in thermal contact with the bottom(50) of said cup (14).

6.           The integrated circuit package of claim 5, characterized in that said integrated circuit package (10) includes heat sink means  (64) attached to said thermally-conductive layer (62).

7.           The integrated circuit package of claim 2, characterized in that a portion of said coaxial cable-like structures are rectilinear in form.

8.           The integrated circuit package of claim 1, characterized in that said package (10) is made via multiple laminations of plastic and metal layers, whereby said metal layers may be adapted to form the walls, vias, central conductors of coaxial cable-like elements, the walls for said elements or other conductive buses required for said package.

9.           The integrated circuit package of claim 1, characterized in that said lip (16) includes perforations (70) therethrough, whereby gases formed during the production of said integrated chip package (10) may be released and such that the lip (16) of said cup (14) may be fixedly attached to said plastic substrate (12).

10.           The integrated circuit package of claim 1, characterized in that portions of said package (10) are made with photopatterning steps including chemical developing followed by plasma etching.

Fig. 1

Fig. 2

Fig. 3

Fig. 4

Fig. 5

Fig. 6

_Fig. 7A_

STAINLESS STEEL CARRIER

100

_Fig. 7B_

102

ADD RELEASE LAYER

_Fig. 7C_

104

APPLY DRY PHOTO RESIST

_Fig. 7D_

108

106     106

1. APPLY POSITIVE ART
2. EXPOSE TO UV LIGHT

_Fig. 7E_

110     110     104

CHEMICALY REMOVE
UNEXPOSED PHOTO RESIST

_Fig. 7F_

112     112

102

COPPER
NICKEL
GOLD

_Fig. 7G_

114

APPLY PHOTO RESIST

0183598

116
118

1. APPLY POSITIVE ART
2. EXPOSE TO UV LIGHT

114

*Fig. 7H*

120          120

1. CHEMICALY REMOVE
UNEXPOSED PHOTO RESIST
2. PLASMA ETCH

*Fig. 7I*

122          122

COPPER PLATE

*Fig. 7J*

124          124

102

CHEMICALY REMOVE
REMAINING PHOTO RESIST

*Fig. 7K*

124    126    124

1. ADD POLYIMID
2. SAND TO EXPOSE VIAS

*Fig. 7L*

128

COPPER STRIKE 1/10 MIL

*Fig. 7M*

128  130

ADD PHOTO RESIST

*Fig. 7N*

132'  128  132  134

1. ADD POSITIVE ART

2. EXPOSE TO UV LIGHT

*Fig. 7O*

136  138  128  136

1. CHEMICALY REMOVE EXPOSED PHOTO RESIST

2. COPPER PLATE

*Fig. 7P*

128  140  144  142

1. ADD PHOTO RESIST

2. ADD POSITIVE ART

3. EXPOSE TO UV LIGHT

*Fig. 7Q*

Fig. 7R

1. STRIP PHOTO RESIST
2. STRIP COPPER STRIKE

Fig. 7S

ADD POLYIMID AND SAND TO EXPOSE VIAS

REPEAT STEPS M THRU S

Fig. 7T

REPEAT STEPS M THRU P

Fig. 7U

ADD POLYIMID AND SAND TO EXPOSE VIAS